## Europäisches Patentamt
## European Patent Office
## Office européen des brevets

(19)

(11) Publication number: **0 013 979**
**B1**

(12)

# EUROPEAN PATENT SPECIFICATION

(45) Date of publication of patent specification: 04.05.83

(21) Application number: 80100335.1

(22) Date of filing: 23.01.80

(51) Int. Cl.³: **H 05 K 13/02, H 05 K 3/00, B 65 G 47/91**

(54) Electronic parts mounting apparatus.

(30) Priority: 25.01.79 JP 7764/79

(43) Date of publication of application:
06.08.80 Bulletin 80/16

(45) Publication of the grant of the patent:
04.05.83 Bulletin 83/18

(84) Designated Contracting States:
DE FR GB NL

(56) References cited:
EP - A - 0 002 496
DE - A - 1 919 591
DE - A - 2 064 129
DE - A - 2 614 002
DE - A - 2 740 909
US - A - 3 465 874
US - A - 3 809 221
US - A - 4 116 348

(73) Proprietor: Matsushita Electric Industrial Co., Ltd.
1006, Oaza Kadoma
Kadoma-shi Osaka-fu, 571 (JP)

(72) Inventor: Araki, Shigeru
3-4-5, Aoyama
Katano-shi, Osaka-fu (JP)
Inventor: Taki, Yasuo
51-7, Nishifunahashi 2-chome
Hirakata-shi, Osaka-fu (JP)
Inventor: Mori, Kazuhiro
16-17, Myokenzaka 3-chome
Katano-shi, Osaka-fu (JP)
Inventor: Misawa, Yoshihiko
9-207, Ikuno 4-chome
Katano-shi, Osaka-fu (JP)
Inventor: Tanaka, Souhei
10-21-23, Hashiridani 2-chome
Hirakata-shi, Osaka-fu (JP)

(74) Representative: Eisenführ & Speiser
Martinistrasse 24
D-2800 Bremen 1 (DE)

Courier Press, Leamington Spa, England.

# Electronic parts mounting apparatus

The present invention relates to an apparatus for mounting electronic parts and, more particularly to a supplying installation for conveying and placing onto an electronic circuit board electronic parts having at least two straight parallel edges, said installation including a flexible carrier strip holding said parts at equal intervals in a line; means for holding said strip in its wound state; means for feeding intermittently said strip by pitches corresponding to said intervals in one direction; means for picking up said parts one by one from said strip; and means for moving said pick-up means together with said parts to a given position to place said parts onto said circuit board.

The apparatus of this kind known from DE—A—26 14 002 and DE—A—27 40 909 is designed and adapted to supply, for mounting on a circuit board, lead-type electronic parts such as chip-type resistors and chip-type capacitors (hereinafter referred to as chip parts), the parallel leads of said parts being held and fixed, on opposite sides, between two parallel tapes, which leave the electronic parts proper exposed. In addition the outer dimensions of the electronic parts exceed those of the leads and the carrier tapes, thereby impairing storage and handling of the carried parts.

From US—A—3 465 974 a carrier for electronic parts of the leadless type (hereinafter referred to as chip parts) was known, which is comprised of a carrier strip having a row of hollows each receiving one of such chip parts, and being closable by a cover tape that can be attached to the strip. The hollows of said strip are dimensioned so as to maintain the position and orientation of the individual chips so that they can be presented to an automatic die attach machine without any intermediate handling. In such an arrangement employing hollows with dimensional accuracy high enough to ensure very accurate orientation would not only increase the costs involved, but also require considerable withdrawing force to take the chips out of the individual hollows into which they have been pressed. In addition, accurate positioning would be warranted only as long as no outer mechanical forces occur, since an impact to the strip may displace the chips held inside the strip hollows.

US—A—4 116 348 discloses an apparatus employing vacuum heads each movable between a first position at which it picks up an oriented component chip from an elongated tray, and a second position over a circuit substrate position on an x—y table at which it places the chip at the desired position on the substrate.

It is the object of the present invention to improve and facilitate supplying of electronic chip parts to a mounting apparatus by means of a flexible carrier strip.

According to the invention this problem is solved by altering the known apparatus referred to initially in that said strip has, in a manner known per se, a row of hollows at said intervals each receiving one of said parts, and closed by a cover tape attached to the strip; said hollows being dimensioned so as to loosely accommodate said parts; separating means separate said tape from said strip; disposing means support said strip, upon separation of said tape, horizontally so as to dispose said parts received within that hollows to the top side; and regulating means are associated with said pick-up means including at least one pair of jaws which can be closed against said parallel edges of said parts, for correcting slight errors in orientation of said parts before they are placed onto said circuit board.

The electronic chip parts are thus maintained, within the hollows of the carrier strip, at an approximately constant orientation only, and the orientation is made perfect only after withdrawal of the parts from the tape compartments with the aid of the adjusting or regulating means. The manufacturing costs of the strip are low, the loose fit of the components within the strip compartments permits the components to escape to a certain extent the damaging effect of mechanical forces impinging from outside, and low suction force is required to withdraw the electronic parts after removal of the cover tape. With other words, contrary to the relevant prior art, it is the combination of the loose accommodation of the electronic chip parts within the spaces provided by the strip, and the interaction thereof with the combination of pick-up and orienting or regulating means which achieves the desired result.

There now follows a detailed description of one preferred embodiment taken in conjunction with the accompanying drawings, in which:—

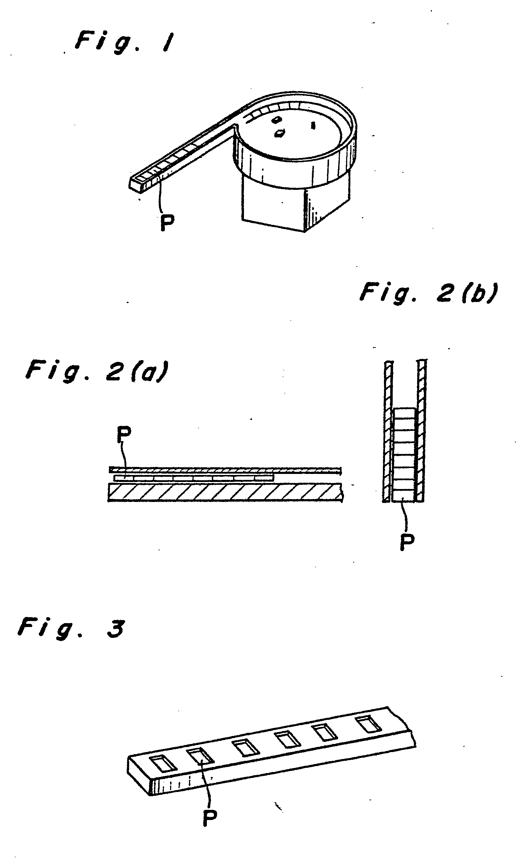

Fig. 1 is a perspective view showing an oscillation type feeding hopper employed within conventional apparatus;

Fig. 2, (a) and (b), shows cross-sectional views each showing a guide shoot employed within conventional apparatus;

Fig. 3 is a perspective view showing a carrier magazine employed within conventional apparatus;

Fig. 4 is a top plan view showing one embodiment of a chip parts carrier to be used in the apparatus in accordance with the present invention;

Fig. 5 is a cross-sectional view of the chip parts carrier of Fig. 4;

Fig. 6 is a top plan view showing another embodiment of a chip parts carrier for use in apparatus in accordance with the present invention;

Fig. 7 is a cross-sectional view of the chip parts carrier of Fig. 6;

Fig. 8 is a perspective view showing one embodiment of a chip parts mounting apparatus of the present invention;

Fig. 9(a) is a partial cross-sectional view showing a chip parts pick-up mechanism employed within the apparatus of Fig. 8;

Fig. 9(b) is an enlarged side-elevational view of one portion of a feed pawl employed in the mechanism of Fig. 9(a);

Fig. 10 is a front view taken along a line A—A in Fig. 9(a);

Fig. 11 is a side-elevational view taken along a line C—C in Fig. 10;

Fig. 12 is a bottom view taken along a line B—B in Fig. 9(a);

Fig. 13 is a front view similar to Fig. 10 in a condition where the position regulating pawls are open;

Fig. 14 is a bottom view similar to Fig. 12 in a condition where the position regulating pawls are open;

Fig. 15(a) through (d), are schematic views showing the position regulating means for the chip parts employed within the apparatus of Fig. 8, for the purpose of illustrating how to regulate the position of a chip part; and

Fig. 16 is a plan view, partially broken away, in an enlarged scale, showing a driving mechanism for the feed pawl employed within the apparatus of Fig. 8.

Before the description of the present invention proceeds, it is to be noted that like parts are designated by like reference numerals throughout the accompanying drawings.

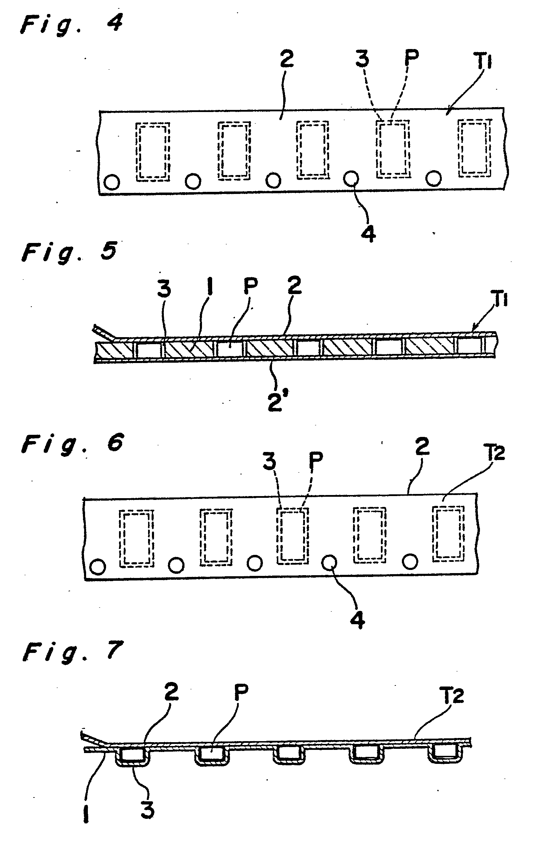

Referring first to Figs. 4 to 7, these show two embodiments of band carriers T for use in an apparatus of the present invention, each of which includes a strip band 1 of flexible plate having a lot of hollows 3 at equal intervals in a line each receiving a chip P therein and a sheet tape 2 attached so as to cover all of the hollows 3, said carrier T providing a lot of perforations 4 at equal intervals corresponding to the hollows 3 for detachably engaging with a receiprocating pawl 11 of feeding means provided in the apparatus so as to feed the carrier T by the pawl 11 and being adapted to wind up on a reel 6 provided in the apparatus to form a helical coil provided with one end for drawing out.

Figs. 4 and 5 shows one embodiment of a band carrier T1 comprising a strip band 1 of flexible plastic plate having a lot of holes 3 at equal intervals in a line each for receiving a chip part P therein, the chip parts P being freely dropped and inserted into the receiving holes 3, and a pair of flexible plastic sheet tapes 2 and 2', one tape 2' being fixed by bonding agent, mechanical coupling or thermal adhesion under pressure onto the bottom side of the strip band 1 to cover the rear side openings of the holes 3 so as to form hollow portions of the band 1 for accommodating the chip parts P therein, while the other tape 2 is detachably attached by bonding agent, mechanical coupling or thermal adhesion under pressure onto the front side of the strip band 1 to cover the hollows so as to wrap up the chip parts P to be surrounded by the inner walls of the holes 3 of the strip band and the pair of sheet tapes 2 and 2', the other tape 2 being provided to be able to be removed easily from the strip band 1 by the application of an external force for peeling off the other tape 2. Also, the carrier T1 provides a lot of perforations 4 at equal intervals corresponding to and between the holes 3 along the edge portion thereof, perforations 4 being provided to pass through the strip band 1 and the pair of sheet tapes 2 and 2' with dimensions allowing engagement with the pawl 11 of the apparatus. The carrier T1 is arranged to accommodate the chip parts P within given ones of the hollows 3 by attaching the pair of the sheet tapes 2 and 2' to the strip band 1 and providing the perforations 4 therethrough, and is adapted to wind up on the reel 6 of the apparatus to form a coil having one end for drawing out and feeding to a picking means provided in the apparatus by the engagement of the perforations of the band and the pawl 11 of the apparatus. If and when the tape sheet 2 provided on the front side of the strip band 1 is separated from the strip band 1 upon the application of an external force, the chip parts P are unveiled and adapted to be taken out from the hollows of the carrier T1 to the outside without any trouble.

Figs. 6 and 7 show another embodiment of a band carrier T2 comprising a strip band 1 of flexible metal foil having a lot of concaves 3 at equal intervals in a line to form the hollows for receiving chip parts P therein, the chip parts P being freely dropped and inserted into given positions of the receiving concaves 3, and a flexible paper sheet tape 2 detachably attached by bonding agent, mechanical coupling or thermal adhesion under pressure onto the front side of the strip band 1 to cover the front openings of the concaves 3 so as to wrap up the chip parts P to be surrounded by the inner walls of the concaves 3 of the strip band 1 and the sheet tape 2. The carrier T2 being provided with a lot of perforations 4 at equal intervals corresponding to the hollows 3 each passing through the strip band 1 and the sheet tape 2 with dimensions allowing engagement with the pawl 11 of the apparatus. The carrier T2 is also adapted in the same manner as the carrier T1 for use in the apparatus of the present invention as mentioned hereinafter.

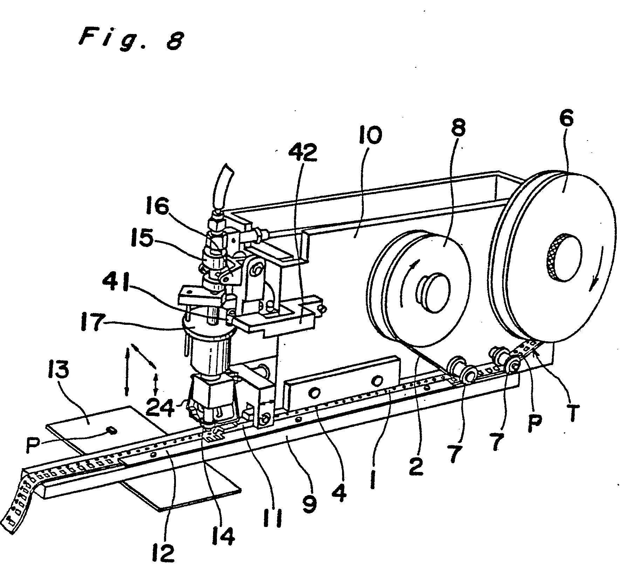

Now, referring to Figs. 8 to 16, there is shown the apparatus of the present invention comprising a body frame 10, a first reel 6 for winding up the carrier T with chip parts P therein, a second reel 8 for winding up the sheet tape 2 being separated from the strip band 1 to unveil chip parts P received within the hollows 3 of the strip band 1 to the outside, a guide rail 9 with a cover 12 for holding the strip band 1 being separated from the sheet tape 2 thereon to guide the band 1 forward with the chip parts P received within the hollows 3 of the band 1 being horizontally placed on the top side, a feeding means including the reciprocating pawl 11 to be engaged with each of perforations 4 provided on the carrier T to feed intermittently said carrier T from its one end by given pitches corresponding to the intervals of the hollows 3 of the band 1 along the guide rail 9, a picking means including a suction head 14 connected with a source of vacuum S for picking up the chip parts P one by one from the hollows 3 of the band 1 in association with the chucking operation of a position regulating mechanism, and a moving means including at least one rod 15 provided on the body frame 10 so as to guide said picking means together with chip parts P to a given position to mount the chip parts P onto a circuit board 13 in association with the shifting operation of a 90° rotary mechanism, the chip parts P of the band carrier T being adapted to be carried from the first reel 6 by the feeding means and to be placed through the picking means and moving means onto the circuit board 13.

Referring to Fig. 8, the band carrier T is wound up on the first reel 6 rotatably mounted on the body frame 10, and the unwound end of the carrier T drawn out from the first reel 6 is guided by a pair of guide rollers 7 and 7 to the guide rail 9. Beyond the guide rollers 7, the sheet tape 2 of the carrier T is peeled off from the strip band T in a known manner to wind up around the second reel 8 which is rotatably mounted on the body frame 10 and is driven to rotate in clockwise direction in synchronization with the operation of the feeding means by a driving means (not shown) provided in the body frame 10, the strip band 1 separated from the sheet tape 2 being guided on the guide rail 9 toward the feeding means.

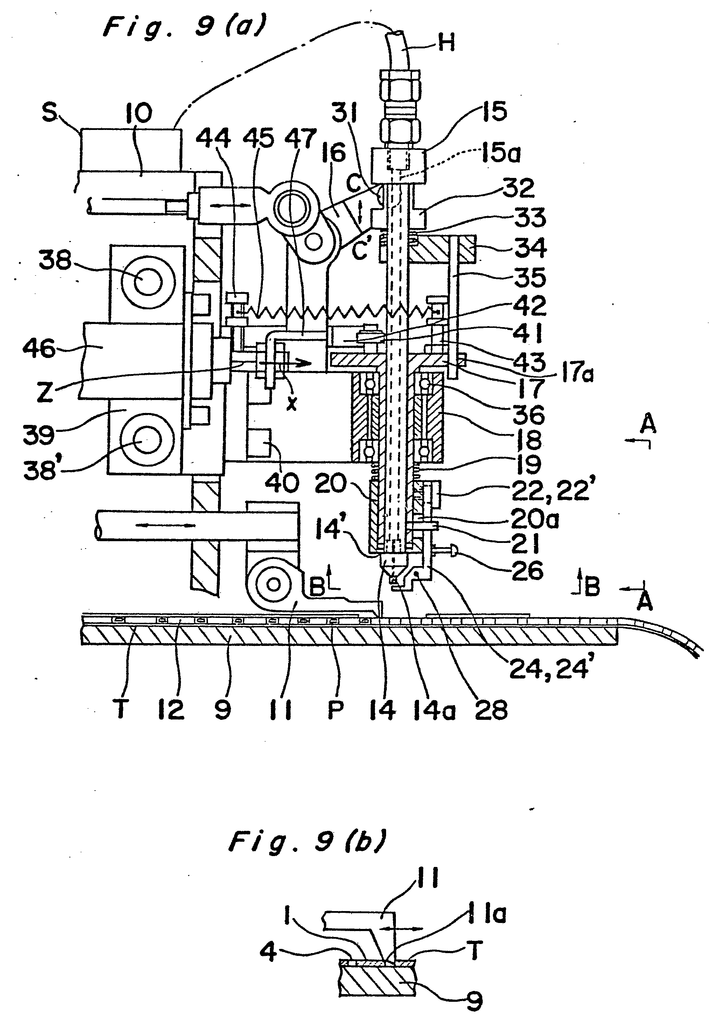

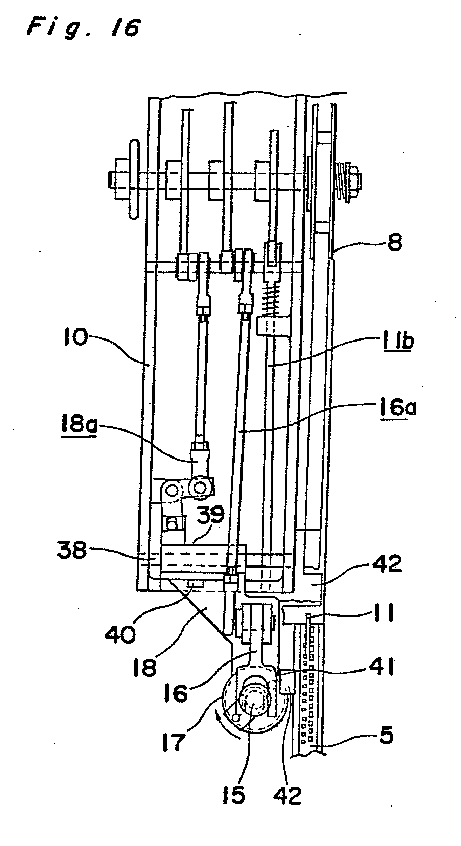

At the front end of the body frame 10, there is provided the reciprocating pawl 11 which is operated to move with reciprocating motion along the guide rail 9 by a conventional driving means and is adapted to engage with each of perforations 4 of the band carrier T to move the carrier T by given pitches towards the picking means. The conventional driving means for the reciprocating pawl 11 is provided within the body frame 10 and includes a crank mechanism 11b driven by a motor (not shown) in a known manner, as shown in Figs. 9 and 16. When the pawl 11 retreats from the advanced position to the initial position in its reciprocating movement, the taper face 11a provided on the front end rear portion of the pawl 11 smoothly rides onto the upper surface of the strip band 1 after disengagement of the pawl 11 from the perforation 4 of the strip band 1, thereby preventing the strip band 1 from moving back, as shown in Fig. 9(b). The strip band 1 together with chip parts P is intermittently fed by the reciprocating motion of the pawl 11 by given pitches corresponding to the intervals of the perforations 4 of the strip band 1 towards the picking means along the guide rail 9.

Near the terminal end of the guide rail 9, there is provided the suction head 14 which is operated to pick up the chip parts P from the strip band 1 by suction in order to carry and place the chip parts P onto the circuit board 13 by the moving means, the circuit board 13 being positioned at a given location on the front end of the body frame 10. When the suction head 14 is operated to pick up the chip parts P from the strip band 1, the feeding means is stopped to fix the strip band 1 at one position, and the feeding means is actuated again to operate the pawl 11 for moving the strip band 1 forward after the chip part P picked up by the suction head 14 is moved away from the strip band 1 upon the actuation of the picking means and the moving means. After completion of one cycle of operations of the picking means and the moving means, which ranges from the feeding operation of the feeding means to the picking and moving operations of the picking means and the moving means in order to carry and mount the chip part P onto the circuit board 13, either the circuit board 13 with the chip parts P mounted on it or the body frame itself is shifted to a given position to replace the circuit board 13 by a new one. Also, by repeating the above cycle, the next chip parts P on the strip band 1 will be mounted onto the new circuit board 13 in succession one after another.

The construction and operation of the picking means and the moving means provided in the frame body 10 will be described hereinafter in detail with reference to Figs. 9 to 16.

Referring to Fig. 9, a suction head 14 of the picking means is coupled as one unit to the lower end of a rod 15, of which upper end is provided with a flange 15a connected with a suction source S through a flexible hose H. The rod 15 with the suction head 14 is mounted to be movable in a vertical, axial direction so as to perform its vertical shift operation, by means of actuating members including roller 31 rotatably mounted on an actuating lever 16, sliding ring 32 slidably mounted on the rod 15, lever 34 secured to the rod 15, and compression spring 33 provided between the sliding ring 32 and the lever 34, said vertical shift operations thereof being caused by swinging of the roller 31 of the lever 16 rotated by an external means 16a (Fig. 16) to push downwardly the lever 34 of the rod 15 through sliding ring 32 and spring 33. The roller 31 does not interfere with the rotation of the sliding ring 32 around the rod 15 and is engaged with the sliding ring 32 or the flange 15a of the rod 15 to move them along the axial direction of the rod 15. The compression spring 33 is provided between the sliding ring 32 and the lever 34 to retain at a given value the depressing force of the suction head 14 against the chip parts P. The rod 15 and the suction head 14 respectively provide along their axes a vertical hole 14a for sucking the chip parts P at the lower end of the suction head 14, said hole being connected, at the upper end of the flange 15a of the rod 15, to the suction source S through the hose H. The rod 15 is slidably inserted into and passed through an axial hole of a rotary boss 17 mounted on a moving block 18 to be supported for the vertically slidable operation thereof. Also, a guide pin 35 which is mounted on the lever 34 of the rod 15 is slidably inserted within a vertical hole 17a of the rotary boss 17 to provide a turning stop for the rotation between the rod 15 and the rotary boss 17. The rotary boss 17 is rotatably supported through bearings 36 in a moving block 18 which is movable horizontally by an external means 18a (Fig. 16). The moving block 18 is fixed by a bolt 40 on a sliding block 39 which is mounted slidably on two guide rods 38 and 38' secured to the body frame 10.

The 90° rotary mechanism for the rod 15 will be described hereinafter with reference to Figs. 8 and 9. A roller 41 is mounted on the rotary boss 17 and is normally urged by a spring means into contact with a cam 42 which is secured to the body frame 10 and is formed of a shape to stop the roller 41 so as to guide the roller 41 to be rotated by the urging force of the spring means. As the spring means, a tension spring 45 is provided between one pin 43 secured to the rotary boss 17 and another pin 44 secured to the moving block 18. The 90° rotary operation of the rotary boss 17 is effected under the guidance of the cam 42 with which the roller 41 of the rotary boss 17 is normally engaged by the spring means during the horizontal movement of the moving block 18 along the guide rods 38, 38' for a given length. A releasing mechanism for the 90° rotary operation of the rod 15 includes a metal stop 47 which is mounted on the actuator of an air cylinder 46 secured to the sliding block 39 so as to move in the direction x (Fig. 9a) through the operation of the air cylinder 46. When the 90° rotation of the rod 15 is intended to be blocked, the stop 47 is advanced by the operation of the air cylinder 46 to fit with a further pin (not shown on the rotary boss 17 thereby depressing the rotary boss 17 at a given location in order to block the urging force of the tension spring 45 for the rotation of the rotary boss 17. This results in releasing the roller 41 from the cam 42.

The position regulating mechanism operating on the carrying and placing operations of the chip parts will be described hereinafter. A sliding boss 20 is slidably provided around the outer periphery of the rotary boss 17 disposed below the bearings 36 and is supported on the suction head 14 of the rod 15 disposed below the rotary boss 17 so as to be slidable in the vertical direction along the rotary boss 17, a compression spring 19 being provided between the bearing 36 and the sliding boss 20 to push the sliding boss 20 toward the suction head 14. A guide pin 21 is secured on the rotary boss 17 and is slidably engaged into a long hole 20a provided in the sliding boss 20, so that the sliding boss 20 is rotated together with the rotary boss 17 on the engagement between the guide pin 21 and the sliding boss 20 and is slidable over a restricted range of movement within the long hole 20a of the sliding boss 20, relatively in the axial direction with respect to the rotary boss 17.

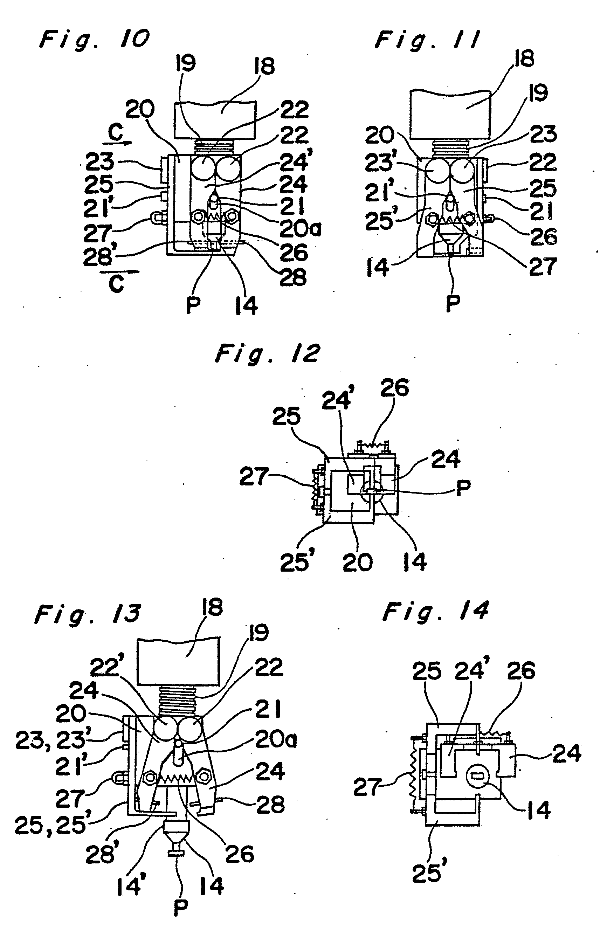

Supporting shafts 22, 22' are clamped, through screws, on one side of the sliding boss 20, and position regulating jaws 24, 24' are rotatably supported, respectively, around the supporting shafts 22, 22'. In Fig. 9, the suction head 14 is in its ascent position together with the rod 15 pulled upward by the roller 31 against the spring 19, the upper shoulder 14' of the suction head 14 pushes up the sliding boss 20 to a position in which the guide pin 21 is positioned at the lower portion of the hole 20a of the sliding boss 20 and the position regulating jaws 24, 24' are closed to contact with each other to clamp the chip part P between the free ends thereof for regulating the position of the chip part P, as shown in Figs. 10 and 11. On the contrary, when the suction head 14 is in its descent position in association with the downward movement of the rod 15, the sliding boss 20 is pushed downwardly by the compression spring 19 to another position in which the guide pin 21 is positioned at the upper portion of the hole 20a to engage between the position regulating jaws 24, 24', so that the free ends of the positioning regulating jaws 24, 24' are moved apart from each other for releasing the chip.

The construction of the position regulating jaws will be described hereinafter in detail with reference to Figs. 10 to 14. Referring to these views, two sets of the supporting shafts 22 and 23, and 22' and 23' are clamped through screws on the two sides, i.e., the front and side elevational plates of the sliding boss 20, the two sides being adjacent and normal to each other. The position regulating jaws 24 and 24', and 25 and 25', are engaged, respectively, with each other through segment gears provided thereon to be guided rotatably in opposite directions around these supporting shafts 22 and 23, and 22' and 23', so positioning the free ends of the position regulating jaws 24 and 24' to face each other on a line within an imaginary horizontal plane disposed below the suction head 14 as shown in Fig. 12, while the free ends of the position regulating jaws 25 and 25' face each other on another line transverse to that line within the imaginary plane. A pair of tension springs 26 and 27 are mounted, respectively, between the position regulating jaws 24 and 24', and between the position regulating jaws 25 and 25' to urge the jaws into closed contact with each other. Fig. 10 to 12 show, respectively, one state of the ascending suction head 14 in which each pair of the position regulating jaws 24, 24' and 25, 25' are kept closed by the urging force of tension springs 26 and 27 to engage the free ends thereof with the four sides of the chip parts P to be sucked by the suction head 14 in order to grasp the chip parts P from four directions of the free ends thereof, while Fig. 13 and Fig. 14 show, respectively, the other state of the descending suction head 14 in which each pair of the position regulating jaws 24, 24' and 25, 25' are kept opened against the urging forces of tension springs 26 and 27 so as to release the chip part P from the position regulating jaws 24, 24' and 25, 25'. Accordingly, referring to these views, as the suction head 14 of the rod 15 is moved down by the clockwise rotation of the lever 16, the sliding boss 20 follows to descend with the suction head 14 under the influence of compression spring 19, while the upper shoulder 14' of the suction head 14 is in contact with the underside of the sliding boss 20, until the upper portion of the long hole 20a comes into contact against the guide pin 21. At this time, since the guide pin 21 is secured to the rotary boss 17 at the fixed position, the position regulating jaws 24, 24' are opened to separate from each other by the guide pin 21 disposed between the position regulating jaws 24 and 24', against the urging force of the tension spring 26, as shown in Fig. 13. Likewise, the position regulating jaws 25, 25' are opened to separate from each other by the guide pin 21' disposed between the position regulating jaws 25 and 25' against the urging force of the tension spring 27. As the suction head 14 of the rod 15 is raised by the counter-clockwise rotation of the lever 16, the two sets of position regulating jaws 24, 24' and 25, 25' are respectively closed to catch the chip part P therebetween as mentioned above.

In addition, a pair of detecting electrodes 28, 28' are provided, respectively, on the position regulating jaws 24, 24', for detecting the presence of the chip part therebetween, as shown in Fig. 13. When the suction head 14 fails to suck the chip part P thereon between the regulating jaws 24, 24', the closing amount of the position regulating jaws 24, 24' increases by the rotations of the position regulating jaws 24, 24' until the facing ends of the electrodes 28, 28' are brought into contact directly with each other and an external circuit, not shown, to be connected with the detecting electrodes 28, 28' is energized by closing the electrodes 28, 28' to detect the absence of the chip part P on the suction head 14. On the contrary, when the chip part P is sucked by the suction head 14, the external circuit is not energized because an opening remains between the electrodes 28, 28'.

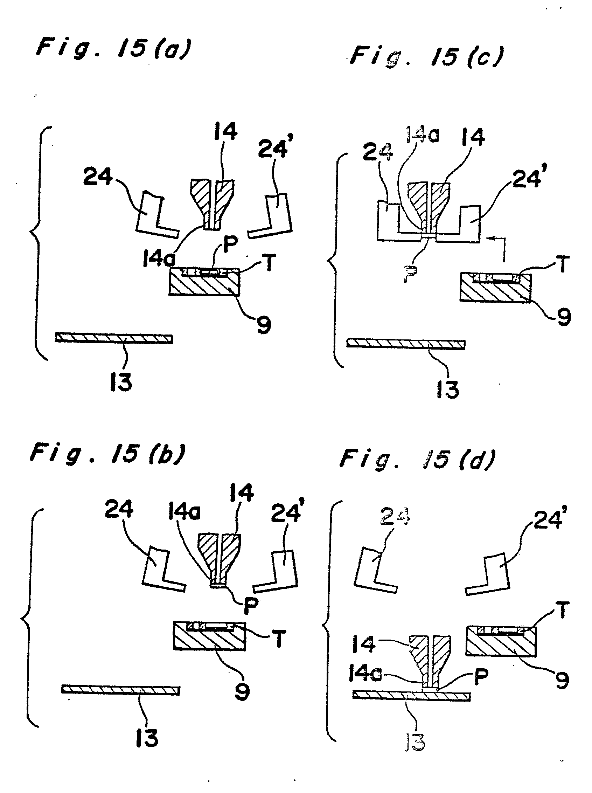

The operation of the apparatus having the construction mentioned above will be described hereinafter with reference to Fig. 9 to Fig. 15. Referring to the view of Fig. 15, (a) to (d), only the position regulating jaws 24 and 24' are shown for the sake of brevity, and the operation of the position regulating jaws 25 and 25' will easily be understood to correspond to that of the position regulating jaws 24 and 24'.

Referring to Fig. 15(a), the chip parts P are delivered in one row by the guide rail 9. Firstly, the position regulating jaws 24, 24' are open when the suction head 14 goes to the chip part P received on the band 1. Then, Fig. 15(b) shows how the chip part P is sucked by the suction head 14 and, at this time, the position regulating jaws 24, 24' are kept open. In Fig. 15(c), the position regulating jaws 24, 24' are closed, while the suction head 14 carries the chip part P from the guide rail 9 to a given position on the circuit board 13, to regulate the position of the chip part P. In Fig. 15(d), the position regulating jaws 24, 24' are opened to descend the suction head 14, thereby to place the chip part P on the boad 13.

In the condition of Fig. 9(a) corresponding to that of Fig. 15(a), when the lever 16 is turned in the clockwise direction C' by means of an external means such as a cylinder in a known manner, the sliding ring 32 is downwardly depressed in accordance with the positioning of the lever 16 by the roller 31 the urging force of which is transmitted downwards through the compression spring 33 to descend the rod 15 through the lever 34. When the suction head 14 descends with the rod 15 and comes into contact with the chip part P arranged on and delivered by the guide rail 9, the suction of the vacuum source S is applied through the holes 15a, 14a to suck one chip part to the suction head 14. Also, the sliding boss 20 is pushed downwardly by the resilient force of the spring 19 to open the position regulating jaws 24, 24' and 25, 25' between which the guide pins 21, 21' of the rotary boss 17 are inserted against the resilient force of the springs 26 and 27, as shown in Fig. 13. After sucking the one chip part P on the suction head 14, the lever 16 is turned in the counter-clockwise direction C to raise the suction head 14 together with the rod 15 and lever 34 through spring 33 and ring 32. A condition where the upper shoulder 14' of the suction head 14 is moving upwards into contact with the underside of the sliding boss 20 against the spring 19 corresponds to Fig. 15(b). When the lever 16 is turned by a given stroke in the direction C against the resilient force of the spring 19, sliding boss 20 is raised by the suction head 14 until the position regulating jaws 24, 24' and 25, 25' release from the guide pins 21, 21' causing them to be closed by tension springs 26 and 27 to catch the chip part sucked by the suction head 14 therebetween.

Accordingly, the position regulating jaws 24, 24' and 25, 25' are closed, respectively, to catch the chip part P the presence of which is detected by the detecting electrodes 28, 28'. The movement of the chip part P can be smoothly performed, since the chip part is moved together with the suction head 14 along the sliding direction of the rod 15 which is parallel to a direction with respect to suction of the chip part P by the suction head 14 and is normal to a direction of movement of the moving block 18. Fig. 15(c) shows a condition where the moving block 18 is moved to a given position in its slidable direction along the guide rods 38, 38' by conventional external means with the chip part P being regulated in position by the suction head 14 and the position regulating jaws 24, 24' and 25, 25', the rod 15 and the suction head 14 being rotated by the 90° rotary mechanism if necessary. Through turning of the lever 16 in the clockwise direction C' from this condition, the rod 15 and the suction head 14 descend causing the guide pins 21, 21' to be placed at the upper portion of the hole 20a to open the position regulating jaws 24, 24' and 25, 25'. Before the upper shoulder 14' of the suction head 14 separates from the sliding boss 20, the sliding boss 20 is descended by the urging force of the compression spring 19 and the guide pins 21, 21', are relatively ascended with the hole 20a by a given stroke to open the position regulating jaws 24, 24' and 25, 25'. When the suction head 14 makes further descent by the turning operation of the lever 16, only the suction head 14 reaches onto the board 13 to engage the next chip part P with the board 13. Fig. 15(d) shows this condition. This is the end of one cycle of operations of the apparatus.

The apparatus described has advantages in that the chip parts can be positively fed to a given position and be properly regulated in position during the sucking, carrying and placing operations of the chip parts. The presence of the parts to be sucked by the suction head is detected through the positioning of the position regulating jaws.

## Claims

1. A supplying installation for conveying and placing onto an electric circuit board electronic parts having at least two straight parallel edges including

a flexible carrier strip holding said parts at equal intervals in a line;

means for holding said strip in its wound state;

means for feeding intermittently said strip by pitches corresponding to said intervals in one direction;

means for picking up said parts one by one from said strip; and

means for moving said pick-up means together with said parts to a given position to place said parts onto said circuit board

characterized in that

1. a) said strip (T) has, in a manner known per se, a row of hollows (3) at said intervals each receiving one of said parts (P), and closed by a cover tape (2) attached to the strip;

b) said hollows (3) being dimensioned so as to loosely accommodate said parts (P);

2. a) separating means (8, 12) separate said tape (2) from said strip (T);

b) disposing means (9) support said strip (T), upon separation of said tape (2), horizontally so as to dispose said parts (P) received within that hollows (3) to the top side; and

c) regulating means (24, 25) are associated with said pick-up means (14, 15) including at least one pair of jaws (24, 24'; 25, 25') which can be closed against said parallel edges of said parts, for correcting slight errors in orientation of said parts before they are placed onto said circuit board (13).

2. An installation as defined in Claim 1, wherein said carrier strip (T) comprises a band (1) of flexible plate having a plurality of holes spaced at equal intervals in a line, a tape (2') attached to the bottom side of the band (1) to cover the bottom side opening of the holes to form the hollows (3) for receiving the electronic parts (P) therein, and another tape (2) attached to the top side the band (1) to cover the hollows (Fig. 5).

3. An installation as defined in Claim 1, wherein said carrier strip (T) comprises a band (1) of flexible foil having a plurality of concaves spaced at equal intervals in a line to form the hollows (3) for receiving electronic parts (P) therein and a tape (2) attached to the band (1) to cover all of the hollows (Fig. 7).

4. An installation as defined in Claim 1, wherein said holding means includes a reel (6) on which the carrier strip (T) is wound.

5. An installation as defined in Claim 1 and 2 or 3, wherein said separating means includes a reel (8) for winding up the tape (2) separated from the band (1).

6. An installation as defined in Claim 1, wherein said feeding means includes a reciprocating pawl (11) to be engaged with each of perforations (4) provided on the strip (T) at equal intervals corresponding to those between the hollows (3) to advance the strip (T) by the given pitch.

7. An installation as defined in Claim 1, wherein said disposing means includes a guide rail (9) for guiding the strip (T) thereon to feed the strip (T) to the picking-up means by the operation of the feeding means.

8. An installation as defined in Claim 1, wherein said picking-up means includes a suction head (14) connected with a source of vacuum for sucking the electronic parts (P) from the strip (T).

## Patentansprüche

1. Zuführeinrichtung zum Transportieren von elektronischen Teilen mit mindestens zwei geraden parallelen Kanten sowie zu deren Anordnung auf einer elektrischen Leiterplatte, mit

einem flexiblen Trägerband, welches die Teile mit gleichen Abständen in einer Reihe hält;

Mittel zum Halten des Bandes im aufgewickelten Zustand;

Mittel zum intermittierenden Nachschieben des Bandes in einer Richtung um Schritte, welche den Abständen entsprechen;

Mittel zum vereinzelten Aufnehmen der Teile von dem Band; und

Mittel zum Bewegen der Aufnahmemittel mit den Teilen in eine bestimmte Position, um die Teil auf der Leiterplatte anzuordnen.

dadurch gekennzeichnet, daß

1. a) das Band (T) in an sich bekannter Weise eine Reihe von Höhlungen (3) aufweist, die in jenem Abstand angeordnet sind und jeweils eines der Teile (P) aufnehmen, und die durch einen am Band befestigten Deckstreifen (2) abgeschlossen sind;

   b) wobei die Höhlungen (3) so bemessen sind, daß sie die Teile (P) lose aufnehmen;

2. a) Trennmittel (8, 12) den Streifen (2) vom Band (T) abtrennen;

   b) Darbietungsmittel (9) das Band (T) nach dem Abtrennen des Streifens (2) horizontal unterstützen, um die Teile (P) innerhalb der Höhlungen (3) zur Oberseite hin darzubieten; und

   c) Ausrichmittel (24, 25) mit den Aufnahmemitteln (14, 15) verbunden sind, welche mindestens eine Paar von Backen (24, 24'; 25, 25') aufweisen, die gegen die parallelen Kanten der Teile geschlossen werden können, um geringfügige Orientierungsfehler der Teile zu korrigieren, ehe sie auf der Leiterplatte (13) angeordnet werden.

2. Einrichtung nach Anspruch 1, dadurch gekennzeichnet, daß das Trägerband (T) eine Bahn (1) auf flexiblem Plattenmaterial mit einer Mehrzahl von Löchern aufweist, welche in einer Reihe mit gleichen Abständen angeordnet sind, wobei ein auf der Unterseite der Bahn (1) befestigter Streifen (2') die Löcher unterseitig schließt und die Höhlungen (3) zur Aufnahme der elektronischen Teile (P) bildet, während eine weiterer Streifen (2) auf der Oberseite der Bahn (1) befestigt ist, um die Höhlungen abzudecken (Fig. 5).

3. Einrichtung nach Anspruch 1, dadurch gekennzeichnet, daß das Trägerband (T) eine Bahn aus flexibler Folie mit einer Mehrzahl konkaver Ausbuchtungen aufweist, welche in einer Reihe mit gleichen Abständen angeordnet sind und die Höhlungen (3) zur Aufnahme elektronischen Teile (P) bilden, sowie einen an der Bahn (1) befestigten Streifen zum Abdecken sämtlicher Höhlungen (Fig. 7).

4. Einrichtung nach Anspruch 1, dadurch gekennzeichnet, daß die Haltemittel eine Spule (6) aufweisen, auf der das Trägerband (T) aufgewickelt ist.

5. Einrichtung nach Anspruch 1 und 2 oder 3, dadurch gekennzeichnet, daß die Trennmittel eine Spule (8) zum Aufwickeln des vom Band (1) getrennten Streifens (2) aufweisen.

6. Einrichtung nach Anspruch 1, dadurch gekennzeichnet, daß die Mittel zum Nachschieben eine hin- und hergehende Klinke (11) aufweisen, die mit Perforationen (4) in Eingriff gelangt, welche am Band (T) in gleichen, denjenigen zwischen den Höhlungen (3) entsprechenden Abständen angeordnet sind, um das Band (T) um das bestimmte Schrittmaß vorzuschieben.

7. Einrichtung nach Anspruch 1, dadurch gekennzeichnet, daß die Darbietungsmittel eine Führungsschiene (9) zur Führung des Bandes (T) aufweisen, um das Band (T) durch Betätigung der Mittel zum Nachschieben den Aufnahmemitteln zuzuführen.

8. Einrichtung nach Anspruch 1, dadurch gekennzeichnet, daß die Aufnahmemittel einen Saugkopf (14) aufweisen, welcher an eine Unterdruckquelle angeschlossen ist, um die elektronischen Teile (P) vol Band (T) abzusaugen.

**Revendications**

1. Installation d'alimentation pour l'acheminement et le placement sur une plaquette à circuits électriques de pièces électroniques, ayant au moins deux bords rectilignes parallèles, comprenant:

— une bande de transport flexible maintenant les pièces alignées suivant des intervalles égaux;

— un moyen pour maintenir la bande à l'état enroulé;

— un moyen pour alimenter dans un sens par intermittence la bande suivant des par correspondant aux intervalles;

— un moyen pour prélever les pièces une à une sur la bande; et

— un moyen pour déplacer le moyen de prélèvement en même temps que les pièces jusqu'à une position donnée de façon à placer les pièces sur la plaquette à circuits,

caractérisé en ce que:

1. a) la bande (T) comporte, dans une manière connue en soi, une rangée de trous (3) auxdits intervalles, chaque trou recevant l'une des pièces (P), et étant fermé par un ruban de couverture (2) fixé à la bande;

   b) lesdits trous (3) étant dimensionnés de façon à recevoir les pièces (P) avec jeu;

2. a) un moyen de séparation (8, 12) sépare le ruban (2) de la bande (T);

   b) un moyen de disposition (9) supporte la bande (T) lors de sa séparation du ruban (2) dans le sens horizontal, de manière à disposer les pièces (P) reçues à l'intérieur des trous (3) sur le côté supérieur; et

c) un moyen de régulation (24, 25) est associé au moyen de prélèvement (14, 15) comprenant au moins une paire de mâchoires (24, 24'; 25, 25') qui peuvent être fermées contre les bords parallèles des pièces, pour corriger de légères erreurs dans l'orientation des pièces avant qu'elles soient placées sur la plaquette à circuits (13).

2. Installation selon la revendication 1, caractérisée en ce que la bande de transport (T) comprend un ruban (1) constitué d'une plaque flexible ayant une pluralité de trous situés à des intervalles égaux les une des autres suivant une ligne, un ruban (2') fixé au côté intérieur du ruban (1) pour recouvrir l'ouverture du côté inférieur des trous afin de former les cavités (3) destinées à recevoir les pièces électroniques (P), et un autre ruban (2) fixé au côté supérieur du ruban (1) pour recouvrir les cavités (figure 5).

3. Installation selon la revendication 1, caractérisée en ce que la bande de transport (T) comprend un ruban (1) en clinquant flexible ayant une pluralité de parties concaves situées à des intervalles égaux suivant une ligne pour constituer les cavités (3) destinées à recevoir les pièces électroniques (P) et un ruban (2) fixé au ruban (1) pour recouvrir toutes les cavités (figure 7).

4. Installation selon la revendication 1, caractérisée en ce que le moyen de maintien comprend un rouleau (6) sur lequel est enroulée la bande de transport (T).

5. Installation selon les revendications 1 et 2 ou 3, caractérisée en ce que le moyen de séparation comprend un rouleau (8) pour enrouler le ruban (2) séparé du ruban (1).

6. Installation selon la revendication 1, caractérisée en ce que le moyen d'alimentation comprend un cliquet (11) animé d'un mouvement de va-et-vient destiné à venir s'engager dans chacune des perforations (4) pratiquées dans la bande (T) à des intervalles égaux correspondant aux intervalles séparant les cavités (3) de manière à faire avancer la bande (T) suivant le pas donné.

7. Installation selon la revendication 1, caractérisée en ce que le moyen de disposition comprend un rail de guidage (9) pour guider la bande (T) dessus et l'amener jusqu'au moyen de prélèvement grâce au fonctionnement du moyen d'alimentation.

8. Installation selon la revendication 1, caractérisée en ce que le moyen de prélèvement comprend une tête d'aspiration (14) reliée à une source de vide pour aspirer les pièces électroniques (P) et les dégager de la bande (T).

Fig. 1

Fig. 2(b)

Fig. 2(a)

P

P

Fig. 3

P

1

*Fig. 4*

*Fig. 5*

*Fig. 6*

*Fig. 7*

Fig. 8

0013979

Fig. 9 (a)

Fig. 9 (b)

4

0013979

Fig. 10

19 18
20
22
22
C
23 24'
25 24
21' 21
27, 20a
28' 26
C 28
P 14

Fig. 11

18
19
20 23
23' 22
21' 25
25' 21
26
14 27
P

Fig. 12

25 24' 26
27 24
P
25' 20 14

Fig. 13

18
22' 19
24 22
20 21
23,23' 20a
21' 24
27 28
25,25'
28'
26
14' 14
P

Fig. 14

25 24' 26
24
27
14
25'

5

*Fig . 15 (a)*

*Fig . 15 (c)*

*Fig . 15 (b)*

*Fig . 15 (d)*

Fig. 16